# DEMANDE DE BREVET EUROPEEN

(11) **EP 1 376 608 A1**
(43) Date de publication de la demande: **02.01.2004**
(21) Numéro de dépôt: 02291626.6
(22) Date de dépôt: 28.06.2002
(51) Int. Cl.: G11C 16/10

(54) **Procédé d'écriture dans une mémoire non volatile et système pour la mise en oeuvre d'un tel procédé**

(71) Demandeur: CP8, 78431 Louveciennes Cedex (FR)
(72) Inventeur: Siegelin, Christoph, 75015 Paris (FR); Castillo, Laurent, 78100 St. Germain en Laye (FR)

(57) **Abrégé**

La présente invention concerne un procédé d'écriture dans une mémoire de type Flash d'un module électronique. Le procédé consiste :
- à associer au moins deux zones physiques de ladite mémoire dites zones miroir à une même zone logique et lors d'une écriture dans ladite zone logique, à programmer le contenu de ladite zone logique dans une desdites zones miroir vierge ;
- à effacer le contenu de l'ensemble des zones miroir utilisées en une seule opération à un moment opportun.

La présente invention concerne également la carte à puce dans laquelle le procédé est implémenté.

## Description

La présente invention concerne un procédé d'écriture dans une mémoire non volatile d'un ensemble électronique tel que par exemple un système embarqué. Plus précisément, la présente invention vise à proposer un procédé permettant d'optimiser le temps d'écriture à ce type de mémoire.

L'invention concerne encore un système embarqué pour la mise en oeuvre d'un tel procédé.

L'invention s'applique plus particulièrement à une carte à puce.

Dans le cadre de l'invention, le terme "système embarqué" doit être compris dans son sens le plus général. Il concerne notamment toutes sortes de terminaux légers munis d'une puce électronique, et plus particulièrement les cartes à puce proprement dites. La puce électronique est munie elle-même de moyens de traitement d'informations (par exemple un microprocesseur) et de moyens de mémorisation d'informations.

### DOMAINE TECHNIQUE

L'écriture de données persistantes dans une mémoire non volatile d'un système embarqué consiste généralement en une succession d'effacement/programmation de ladite mémoire. L'effacement est un passage à un état « bas » (noté ultérieurement '0') de toutes les cellules mémoires d'une région spécifique (appelée « bloc » ou « page »). La programmation est un passage à un état « haut » (noté '1') d'une portion seulement de la dite région spécifique. L'écriture consiste en l'effacement d'une région et la programmation de bits adéquats de ladite région.

Sur les cartes actuelles, la mémoire non volatile est réalisée en technologie EEPROM. Or les écritures en mémoire EEPROM sont très lentes, de l'ordre de 4 ms. Les temps d'effacement et de programmation sont similaires, de l'ordre de la moitié du temps d'écriture soit de l'ordre de 2 ms. De ce fait, les latences induites par les écritures en mémoire masquent les performances réelles du processeur.

Actuellement, une nouvelle technologie de mémoire non volatile est en cours d'introduction dans les cartes à puces : la technologie Flash. La technologie Flash se distingue de la technologie EEPROM notamment par des caractéristiques très différentes au niveau de la programmation et de l'effacement. Ainsi, dans une mémoire Flash, il existe une forte dissymétrie entre le temps nécessaire pour la programmation, relativement rapide, et le temps nécessaire pour l'effacement d'une cellule précédemment programmée, identique au temps nécessaire pour l'effacement dans une mémoire EEPROM. A titre d'exemple, le temps nécessaire pour la programmation peut atteindre 10 µs (pour une petite quantité de mémoire).

Un but de la présente invention est d'optimiser les temps d'écriture dans une mémoire non volatile d'un ensemble électronique pourvu d'une mémoire de type Flash.

Un autre but de la présente invention est de proposer une solution susceptible d'être implémentée dans un système embarqué.

### RESUME DE L'INVENTION

La présente invention concerne un procédé d'écriture dans une mémoire de type Flash d'un module électronique caractérisé en ce qu'il consiste à associer au moins deux zones physiques de ladite mémoire dites zones miroir à une même zone logique et lors d'une écriture dans ladite zone logique, à programmer le contenu de ladite zone logique dans une desdites zones miroir vierge.

La présente invention concerne également le module électronique comportant des moyens de traitement de l'information, une mémoire non volatile de type FLASH caractérisé en ce qu'il comporte une mémoire miroir constituée d'au moins deux zones physiques et associée à une même zone logique, chaque nouvelle opération de programmation dans ladite zone logique s'effectuant dans une zone de la mémoire miroir vierge ainsi que la carte dans laquelle ledit module est intégré.

### DESCRIPTION SOMMAIRE DES DESSINS

D'autres buts, avantages et caractéristiques de l'invention apparaîtront à la lecture de la description qui va suivre de la mise en oeuvre du procédé selon l'invention et d'un mode de réalisation d'un système électronique adapté pour cette mise en oeuvre, donnés à titre d'exemple non limitatif en référence aux dessins ci-annexés dans lesquels :
- la figure 1 montre une représentation schématique des étapes du procédé selon la présente invention ;
- la figure 2 représente de manière schématique un premier mode de réalisation d'association entre zones logiques et physiques dans le procédé selon la présente invention ;
- la figure 3 représente de manière schématique un deuxième mode de réalisation d'association entre zones logiques et physiques dans le procédé selon la présente invention ;
- les figures 4a à 4c représentent de manière schématique les différents types d'écriture dans la mémoire de type Flash ;
- la figure 5 représente de manière schématique un premier mode de réalisation d'effacement et régénération de zones physiques dans le procédé selon la présente invention ;
- la figure 6 représente de manière schématique un second mode de réalisation d'effacement et régénération de zones physiques dans le procédé selon la présente invention.

### MANIERE DE REALISER L'INVENTION

Le procédé selon l'invention vise à optimiser le temps d'écriture dans une mémoire d'un ensemble électronique, et par exemple un système embarqué tel qu'une carte à puce. L'ensemble électronique comprend au moins un processeur et une mémoire non-volatile de type Flash. Par mémoire de type FLASH, on entend dans la description qui suit toute mémoire non volatile qui présente une dissymétrie entre le temps nécessaire pour la programmation et l'effacement.

Sans que cela limite en quoi que ce soit sa portée, on se placera ci-après dans le cas de l'application préférée de l'invention, à savoir les applications à base de cartes à puce.

La présente invention consiste en un procédé logiciel permettant de tirer profit de la dissymétrie des temps de programmation/effacement d'une mémoire non-volatile, notamment FLASH, pour optimiser les temps d'écriture en mémoire non-volatile d'une carte à puce. A cette fin, on définit une mémoire « miroir » qui est découpée en n zones physiques destinées à contenir une même zone logique du programme.

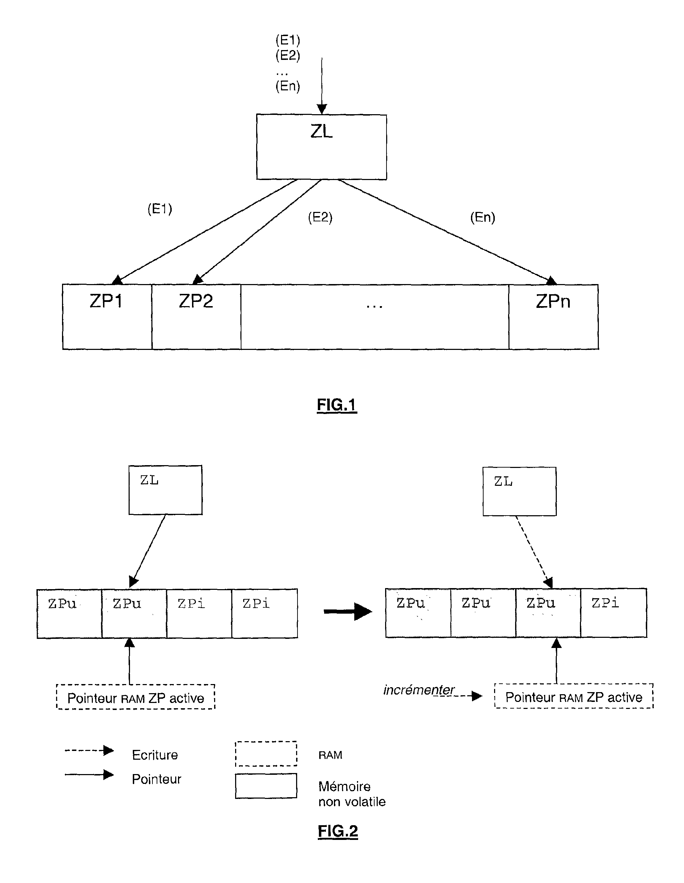

La figure 1 présente un exemple de mécanisme de mémoire miroir.

A l'état initial du système, toutes les zones de la mémoire miroir sont vierges, à savoir de contenu vide, prêtes à recevoir et mémoriser des données. Lorsque le programme souhaite effectuer une écriture E1 dans la zone logique ZL, celle-ci se fait par programmation (rapide) de la première zone physique ZP1. Lors de l'écriture suivante E2 sur cette zone logique ZL, on évite l'effacement (lent) de la première zone physique ZP1 par une programmation dans la deuxième zone physique ZP2 (encore vierge). Ce procédé peut être répété jusqu'à saturation de la mémoire miroir (ou jusqu'à ce que le système saisisse un moment opportun pour effacer les zones physiques utilisées comme il sera vu par la suite).

Pour pouvoir réutiliser l'ensemble des zones physiques, la mémoire miroir doit être effacée périodiquement. L'effacement peut se faire à n'importe quel moment opportun au système, et cet effacement peut profiter du « mode bloc » des mémoires FLASH. En effet, l'optimisation de l'effacement de ces zones physiques se fait, d'une part en effaçant toutes les zones en une seule opération, d'autre part en réalisant l'effacement de façon non bloquante pour le système.

Une première méthode, dite « multiplexage temporel », est une réalisation purement logicielle. L'effacement est effectué par le système de la carte lorsqu'il est en attente, notamment d'un événement extérieur comme une commande du terminal. Une deuxième méthode, dite « multiplexage spatial », nécessite un support matériel pour l'exécution de tâches concurrentes. En effet, la tâche d'effacement est lancée par le système de la carte et s'exécute en parallèle avec le déroulement normal du programme. Cette deuxième implémentation sera réalisée de préférence, soit grâce à une mémoire FLASH bi-port, soit grâce à une mémoire FLASH bi-banque.

En résumé, la séparation du cycle programmation/effacement décrite par l'invention permet de tirer partie des programmations rapides en FLASH, et d'optimiser les effacements de la mémoire. L'invention réalise ainsi un compromis entre utilisation de la mémoire et performances.

Plusieurs modes de réalisation de l'invention sont décrits dans ce qui suit en trois parties :
1^{ère} partie: Réalisation de l'association zone logique/zones physiques.
2^{ème} partie : Algorithme d'écriture d'une zone.
3^{ème} partie : Effacement et régénération des zones physiques.

Il est décrit dans ce qui suit des modes de réalisation de l'association zone logique/zones physiques (1^{ère} partie). L'association zone logique/zones physiques nécessite la connaissance de la zone physique active (la zone « miroir » actuelle dans laquelle le contenu de la zone logique doit être lu). Cette donnée doit être modifiable rapidement lors du changement de zone physique, pour ne pas pénaliser les programmations. Elle doit donc être contenue, soit en RAM, soit dans une zone FLASH préalablement vierge.

Une première réalisation consiste en un simple compteur en RAM, associé à la zone logique, contenant le numéro de la zone active. Le changement de zone se fait par incrémentation du compteur. A l'initialisation de la carte ou en cas d'arrachement, les zones physiques sont parcourues pour déterminer le nombre de zones « utilisées » Zpu, à savoir de zones dans lesquelles le contenu de la zone logique associée à un instant donné a été programmé et pas encore effacé. Le compteur est initialisé avec cette valeur.

La figure 2 illustre une écriture nécessitant un changement de zone physique active pour cette première réalisation.

Une seconde réalisation consiste en un champ de bit en FLASH, associé à la zone logique. Chaque bit représente l'état d'utilisation d'une zone physique ('1' → utilisée; '0' → vierge). Le changement de zone physique se fait par programmation du bit correspondant à la zone vierge nouvellement active. Le champ de bit complet est effacé lorsque toutes les zones physiques sont régénérées. A titre d'exemple, la zone active peut être déterminée comme étant la zone utilisée de poids le plus faible dans le champ de bit.

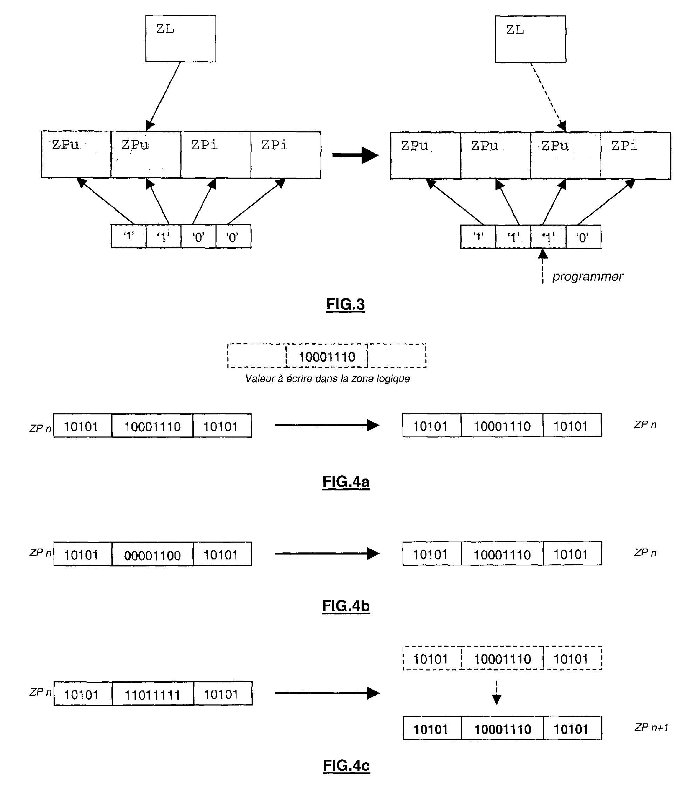

La figure 3 illustre une écriture nécessitant un changement de zone physique active pour cette seconde réalisation.

Il est décrit dans ce qui suit des modes de réalisation de l'algorithme d'écriture d'une zone (2^{ème} partie) en se référant aux figures 4a à 4c illustrant les différentes opérations de comparaison. La zone physique active à gauche contient en gras les bits à modifier. A droite se trouve la nouvelle zone physique active (identique à l'ancienne dans la figure 4a) et les bits effectivement programmés en gras.

Dans l'approche la plus simple, une écriture de la zone logique entière nécessite l'usage d'une nouvelle zone physique, tandis qu'une écriture partielle de la zone logique nécessite la lecture de la zone physique courante, le remplacement de la portion adéquate puis la réécriture dans une nouvelle zone physique. Cette opération peut être optimisée en déterminant s'il est possible de réutiliser la zone physique courante.

Le procédé consiste en la lecture préalable de la zone courante et la comparaison avec la portion à écrire :
- Si les deux contenus sont identiques, rien n'est écrit et la zone physique active reste la même (figure 4a).
- Si les seules opérations nécessaires sont des programmations de bit (i.e. des passages de '0' à '1'), la zone active n'est pas changée et les bits correspondant sont programmés dans la zone courante (figure 4b).
- Sinon, la zone courante est lue et masquée par la portion à écrire, puis le tout est programmé dans une nouvelle zone active (figure 4c).

Il convient de noter que la lecture préalable de la zone courante n'affecte pas les performances du procédé de façon significative, car les lectures en mémoire non-volatile sont rapides, de l'ordre de quelques cycles processeur. Par ailleurs, il est possible de préserver le contenu de la zone courante temporairement en mémoire vive (qui joue alors le rôle d'une antémémoire).

Dans une variante du procédé (figure 4c) décrit ci-dessus, on ne programmera pas l'ensemble de la zone, mais uniquement la partie effectivement différente (grisée dans la figure). Cette variante nécessite une gestion plus complexe, mais elle peut être judicieuse, soit parce que le grain de programmation de la mémoire non-volatile est très grand, soit parce que le temps de programmation par bit est très élevé.

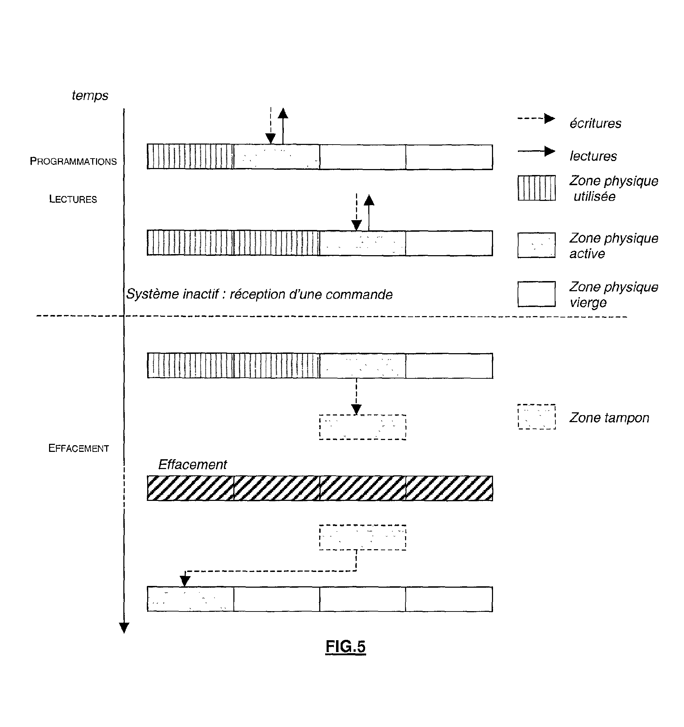

Il est décrit dans ce qui suit des modes de réalisation de la régénération des zones physiques (3^{ème} partie) en se référant à la figure 5.

Le « multiplexage temporel » consiste en la séparation des programmations/effacements dans le temps. En régime normal, le système ne procède qu'à des programmations. Lorsqu'il devient inactif (ou lorsque toutes les zones sont pleines), il effectue leur effacement et se retrouve bloqué pendant cette période. A titre d'exemple, la réception d'une commande sur la ligne l/O d'une carte à puce peut être longue (plusieurs centaines de ms), le système peut en profiter pour déclencher un effacement.

Un mécanisme pour effacer les zones de façon purement logiciel (figure 5) consiste à recopier la zone physique active (le « miroir ») dans une zone tampon, puis à effacer l'ensemble des zones physiques miroirs et enfin à recopier le tampon dans la première zone physique disponible. Ce mécanisme est illustré dans le schéma suivant.

Le « multiplexage spatial » consiste à effectuer en parallèle l'opération d'effacement et les programmations/lectures de la zone logique. La FLASH bi-banque permet une réalisation de ce multiplexage. Les opérations de lecture/programmation/effacement sont en général exclusives sur une FLASH, en particulier il n'est pas possible d'effacer une zone de la mémoire pendant qu'on en programme ou lit une autre. La FLASH bi-banque possède deux banques sur lesquelles il est possible d'effectuer des opérations en parallèle (même si chaque banque a les même contraintes que la FLASH traditionnelle).

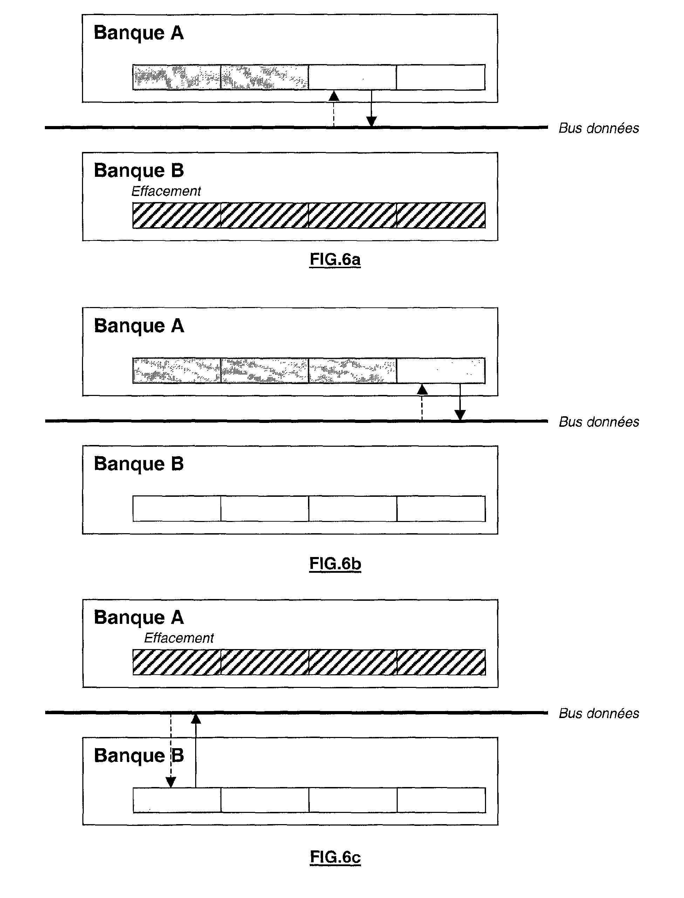

La réalisation sur cette mémoire suppose que la zone logique possède au moins une zone « miroir » dans chaque banque. La banque contenant la zone active est utilisée pour la programmation et la lecture tandis qu'en parallèle, les zones miroirs de l'autre banque sont effacées en bloc (si possible). Le système change de banque active lorsque toutes les zones miroirs de la banque sont épuisées. Les figures 6a à 6c illustrent cette réalisation.

Sur la figure 6a, les programmations/lecture se font sur la banque A pendant que la banque B est effacée.

Dans la figure 6b, B effacée le système continue à travailler sur A jusqu'à saturation des zones physiques.

Dans la figure 6c, lorsque A arrive à saturation, B devient la banque active et le système efface A en parallèle.

## Revendications

1. Procédé d'écriture dans une mémoire de type Flash d'un module électronique **caractérisé en ce qu'**il consiste à associer au moins deux zones physiques de ladite mémoire dites zones miroir à une même zone logique et lors d'une écriture dans ladite zone logique, à programmer le contenu de ladite zone logique dans une desdites zones miroir vierge.

2. Procédé selon la revendication 1, **caractérisé en ce qu'**il consiste à effacer le contenu de l'ensemble des zones miroir utilisées en une seule opération à un moment opportun.

3. Procédé selon la revendication 2, **caractérisé en ce qu'**il consiste à effectuer l'effacement lors d'une période d'inactivité ou lorsque toutes les zones physiques miroir sont utilisées.

4. Procédé selon la revendication 2, **caractérisé en ce qu'**il consiste à effectuer de façon non bloquante les opérations d'effacement et de programmation/lecture en parallèle.

5. Procédé selon l'une des revendications 1 à 4, **caractérisé en ce qu'**il consiste à désigner une des zones physiques comme active à l'aide d'un compteur incrémenté à chaque changement de zone active.

6. Procédé selon l'une des revendications 1 à 4, **caractérisé en ce qu'**il consiste à associer un ensemble de bits à une zone logique représentant l'état d'utilisation des zones physiques miroir de ladite zone logique.

7. Procédé selon l'une des revendications 1 à 6, **caractérisé en ce que** l'écriture est effectuée dans la zone physique active si le contenu de la zone logique est identique par rapport au contenu de la zone physique active ou lorsque ladite écriture ne requiert aucun effacement, et dans une zone physique vierge dans les autres cas.

8. Procédé selon la revendication 7, **caractérisée en ce qu'**il consiste à programmer une partie de la zone logique seulement dans la zone physique vierge.

9. Module électronique comportant des moyens de traitement de l'information, une mémoire non volatile de type FLASH **caractérisé en ce qu'**il comporte une mémoire miroir constituée d'au moins deux zones physiques et associée à une même zone logique, chaque nouvelle opération de programmation dans ladite zone logique s'effectuant dans une zone de la mémoire miroir vierge.

10. Carte **caractérisée en ce qu'**elle comprend le module électronique selon la revendication 9.
